(19) Europäisches Patentamt
European Patent Office
Office européen des brevets

(11) EP 2 180 626 B1

(12) **FASCICULE DE BREVET EUROPEEN**

(45) Date de publication et mention
de la délivrance du brevet:
**20.03.2013 Bulletin 2013/12**

(51) Int Cl.:
***H04L 1/00*** *(2006.01)*

(21) Numéro de dépôt: **09172038.3**

(22) Date de dépôt: **02.10.2009**

(54) **Turbocodeur distribué pour canaux à évanouissements par blocs**

Turbokodierer für Kanäle mit blockweisem Signalschwund

Distributed turbo encoder for block fading channels

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **22.10.2008 FR 0857166**

(43) Date de publication de la demande:
**28.04.2010 Bulletin 2010/17**

(73) Titulaire: **Commissariat à l'Énergie Atomique et aux Énergies Alternatives**
**75015 Paris (FR)**

(72) Inventeurs:
• **CALVANESE STRINATI, Emilio**
**38000 Grenoble (FR)**
• **DE DOMENICO, Antonio**
**38000 Grenoble (FR)**

(74) Mandataire: **Augarde, Eric**
**BREVALEX**
**56 Boulevard de l'Embouchure,**
**Bât. B**
**B.P. 27519**
**31075 Toulouse Cedex 2 (FR)**

(56) Documents cités:
WO-A-2007/064249      WO-A-2008/109912
FR-A- 2 800 947      US-A1- 2008 065 946

• VALENTI M C ET AL: "Distributed turbo codes: towards the capacity of the relay channel" VEHICULAR TECHNOLOGY CONFERENCE, 2003. VTC 2003-FALL. 2003 IEEE 58TH ORLANDO, FL, USA 6-9 OCT. 2003; [IEEE VEHICULAR TECHNOLGY CONFERENCE], PISCATAWAY, NJ, USA,IEEE, US, 6 octobre 2003 (2003-10-06), pages 322-326Vol.1, XP010700782 ISBN: 978-0-7803-7954-1
• ZHAO B ET AL: "Distributed turbo coded diversity for relay channel" ELECTRONICS LETTERS, IEE STEVENAGE, GB, vol. 39, no. 10, 15 mai 2003 (2003-05-15), pages 786-787, XP006020339 ISSN: 0013-5194

**Description**

## DOMAINE TECHNIQUE

La présente invention concerne de manière générale les systèmes de communication de type coopératif. Elle trouve notamment à s'appliquer dans les systèmes 3GPP LTE, Wi-MAX,3GPP LTE-Advanced et les réseaux locaux sans fil (WLANs).

## ÉTAT DE LA TECHNIQUE ANTÉRIEURE

Les systèmes de communication sans fil de type coopératif sont connus pour offrir une couverture plus importante et une moindre susceptibilité aux évanouissements (*fading*) que les systèmes cellulaires classiques. On trouvera par exemple une description des systèmes sans fil de type coopératif dans l'article de J.N Lanemann et G.W. Wornell intitulé « Exploiting distributed spatial diversity in wireless networks » publié en Octobre 2000 dans Proc. Allerton Conf. on Comm,. Contr., Computing.

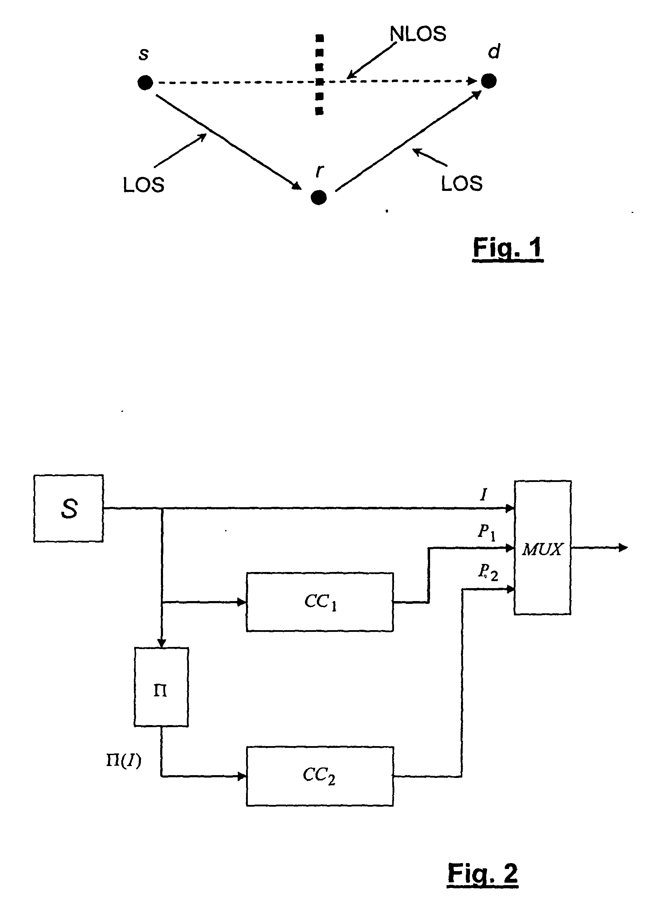

La Fig. 1 représente schématiquement une stratégie de coopération dans un tel système. Le terminal source *s* transmet un flux de données à un terminal destinataire *d*. Le terminal *r* reçoit également le flux de données issu de *s* et le relaie au terminal destinataire *d*. Le terminal *r* coopère ainsi à la transmission de données entre *s* et *d*. Par exemple si le canal *s-d* est de mauvaise qualité, par exemple à cause de la présence d'un obstacle entre *s* et *d* ou d'un évanouissement, le canal *s-r-d* peut permettre d'y remédier et d'obtenir une qualité de liaison satisfaisante. Le flux de données peut être relayé par plusieurs terminaux pour augmenter davantage la diversité spatiale des trajets de transmission. En outre, il peut être relayé en une seule fois (*single-hop*) ou en plusieurs fois (*multiple-hop*). Le relais peut se contenter de retransmettre, après amplification, le signal qu'il reçoit de la source (protocole dit AF pour *Amplify and Forward*) ou bien décoder préalablement le signal avant de le réémettre (protocole dit DF pour *Decode and Forward*).

Dans un autre domaine des télécommunications, les turbocodes introduits par C. Berrou et al. dans l'article séminal intitulé « Near Shannon limit error-correcting coding and decoding : Turbo Codes », Proceedings of ICC'93 pp. 1064-1070, ont fait l'objet de nombreuses recherches. Les performances remarquables des turbocodes en termes de taux d'erreur binaire ou BER (Bit *Error Rate*), proches de celles d'un codage aléatoire, s'expliquent par la présence d'un ou de plusieurs entrelaceur(s) entre différents codeurs élémentaires.

On a illustré en Fig. 2 un exemple de structure d'un turbocodeur. Les bits d'information *I* issus de la source **S** sont codés par deux codeurs élémentaires de type convolutif systématique, disposés en parallèle. Chacun de ses codeurs élémentaires ($RSC_1$, $RSC_2$) est constitué d'une voie systématique, laissant par définition les bits d'information *I* inchangés, et d'un codeur convolutif ($CC_1$, $CC_2$). Le codeur convolutif $CC_1$ fournit les bits de parité $P_1$ en fonction des bits d'information *I*. Le codeur convolutif $CC_2$ fournit en revanche des bits de parité $P_2$ en fonction des bits d'information préalablement entrelacés par l'entrelaceur $\Pi$. Un multiplexeur *MUX* multiplexe ensuite les bits $I, P_1, P_2$ sur le canal de transmission.

De manière plus générale un turbocodeur (de type parallèle) résulte de la concaténation parallèle d'une pluralité de codeurs convolutifs systématiques $RSC_1, ..., RSC_N$, identiques ou non, dont les entrées sont entrelacées par des lois d'entrelacement distinctes. On trouvera une description d'un tel turbocodeur dans l'article de D. Divsalar et al. intitulé « Multiple turbo codes » publié dans Proc. IEEE MILCOM pp. 279-285, 1995. Le nombre *N* de codeurs élémentaires est appelé dimension du turbocode. Les performances du turbocode sont intrinsèquement liées aux caractéristiques des lois d'entrelacement. On comprend en effet que plus celles-ci sont chaotiques, plus la longueur de contrainte du code est grande et plus le code est robuste au bruit.

L'idée de réaliser un turbocodeur distribué entre un terminal source et un terminal relais d'un système coopératif a été récemment proposée par M. Janani et al. dans l'article intitulé « Coded cooperation in wireless communications : space-time transmission and iterative decoding » publié dans IEEE Trans. Signal Process., vol. 52, No. 2, pp. 362-371, Feb. 2004.

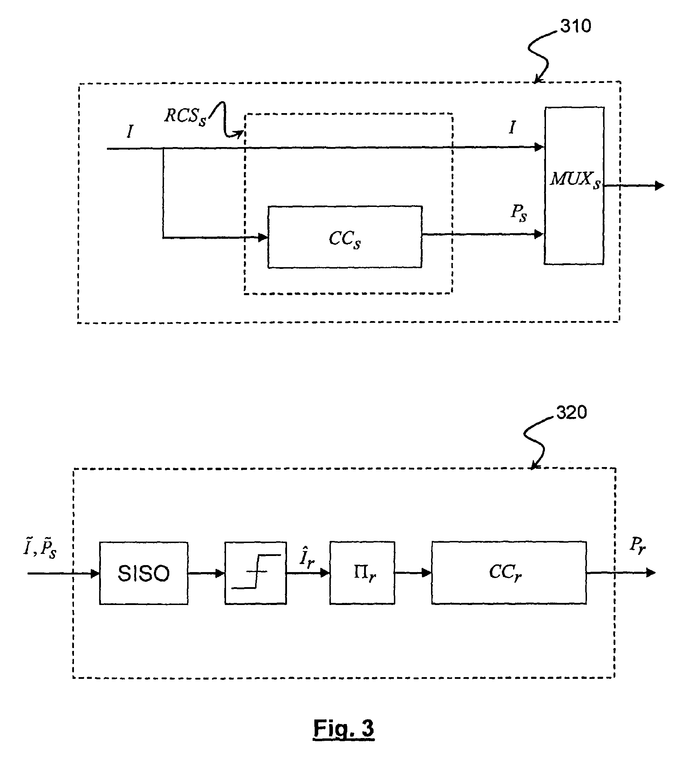

La Fig. 3 illustre de manière schématique la structure d'un turbocodeur distribué entre un terminal source *s* et un terminal relais *r*. On a distingué en 310 et 320 les parties du turbocodeur résidant respectivement sur le terminal source et sur le terminal relais.

Le terminal source s comprend un premier codeur convolutif systématique $RCS_s$. Les bits d'information *I* sont laissés invariants par la voie systématique du codeur $RCS_s$ et codés par le codeur convolutif $CC_s$ en des bits de parité désignés ici par $P_s$. Un muliplexeur $MUX_s$ multiplexe les bits *I* et $P_s$ avant transmission.

Le terminal relais r reçoit le flux de bits ainsi multiplexés et estime les bits d'information *I* au moyen d'un décodeur Viterbi à sorties souples dit SOVA (*Soft Output Viterbi Algorithm*). Au terme du décodage, une décision dure est prise sur les valeurs souples des bits ainsi décodés. Les valeurs dures, notées ici $\hat{I}_r$, sont ensuite entrelacées dans un entrelaceur $\Pi_r$ avant d'être codées dans un second codeur convolutif $CC_r$. Les bits de parité $P_r$ fournis par le second codeur sont ensuite transmis au terminal de destination *d*.

On comprend que les codeurs $CC_s$ et $CC_r$ jouent ici le même rôle que les codeurs convolutifs $CC_1$ et $CC_2$ dans le turbocodeur de la Fig. 2, autrement dit les parties 310 et 320 réalisent conjointement un turbocodage des bits d'information *I*.

Le terminal de destination *d* reçoit d'une part les bits d'information *I* et les bits de parité $P_s$ du terminal source et d'autre part les bits de parité $P_r$ du terminal relais. Le flux de bits reçus fait l'objet d'un décodage itératif mettant en oeuvre le même nombre de décodeurs que de codeurs élémentaires dans le turbocodeur distribué, dans lequel les décodeurs mettent à jour et échangent les valeurs extrinsèques relatives aux différents bits d'information. Dans le cas présent le terminal de destination comprend deux décodeurs du type SISO (*Soft In Soft Out*) par exemple des décodeurs du type MAP (*Maximum A Posteriori*) ou du type SOVA (*Soft Output Viterbi Decoder*).

Ce type de turbocodage distribué fonctionne bien lorsque les canaux de transmission sont gaussiens et plus précisément de type AWGN (Additive *White Gaussian Noise*). Un canal AWGN est modélisé par un coefficient de transmission et une variance de bruit. En pratique toutefois, les canaux de transmission des systèmes de transmission sans fil subissent des évanouissements (*Rayleigh fading*) qui peuvent sévèrement limiter les performances du turbocode en termes de BER pour un rapport signal à bruit donné. Plus précisément, le canal peut être modélisé comme variable dans le temps, présentant des instances à faible évanouissement et des instances à fort évanouissement (*deep fading*).

D'autres exemples de systèmes de communication sont décrits dans les documents de l'art antérieur suivants : WO 2008/109912, FR 2 800 947, US 2008/065946, WO 2007/064249, l'article de VALENTI M C et al.: "Distributed turbo codes: towards the capacity of the relay channel" VEHICULAR TECHNOLOGY CONFERENCE, 2003. VTC 2003-FALL. 2003 IEEE 58th ORLANDO, FL, USA 6-9 Oct. 2003; IEEE VEHICULAR TECHNOLGY CONFERENCE, PISCATAWAY, NJ, USA,IEEE, US, 6 octobre 2003 (2003-10-06), pages 322-326 Vol.1, XP010700782 ISBN: 978-0-7803-7954-1; et l'article de ZHAO B et al.: "Distributed turbo coded diversity for relay channel" ELECTRONICS LETTERS, IEE STEVENAGE, GB, vol. 39, no. 10, 15 mai 2003 (2003-05-15), pages 786-787, XP006020339 ISSN: 0013-5194.

Un objet de la présente invention est donc de proposer une structure de turbocodeur distribué qui soit plus résistante en termes de taux de BER aux évanouissements du canal de transmission (source-destination et relais-destination) que les turbocodeurs distribués de l'art antérieur.

## EXPOSÉ DE L'INVENTION

La présente invention est définie par un système de communication coopératif comprenant un terminal source, au moins un terminal relais, et un terminal de destination, le terminal source étant adapté à transmettre des données d'information au terminal de destination sur un premier canal de transmission multi-porteuse, ledit système comprenant un turbocodeur distribué entre ledit terminal source et au moins ledit terminal relais, la partie du turbocodeur résidant sur le terminal source, dite première partie comprenant une première voie systématique et au moins une première voie de codage convolutif codant lesdites données d'information pour générer des premières données de parité, le terminal relais estimant lesdites données d'information à partir d'un signal reçu du terminal source, la partie du turbocodeur résidant sur le terminal relais, dite seconde partie comprenant une seconde voie systématique fournissant les données d'information ainsi estimées et une seconde voie de codage convolutif codant celles-ci après les avoir entrelacées pour générer des secondes données de parité, lesdites données estimées et lesdites secondes données de parité étant transmises sur un second canal de transmission multi-porteuse. Ledit système comprend au moins un ordonnanceur de fréquences résidant sur le terminal source ou le terminal relais, ledit ordonnanceur allouant les porteuses présentant un fort évanouissement aux données issues respectivement de la première ou de la seconde voie systématique et les porteuses présentant un faible évanouissement aux données issues respectivement de la première ou de la seconde voie de codage convolutif.

Selon un premier mode de réalisation, le système de communication coopératif comprend un premier ordonnanceur de fréquences résidant sur le terminal source et recevant en entrée lesdites données d'information systématique et lesdites premières données de parité et allouant les porteuses à fort évanouissement aux premières et les porteuses à faible évanouissement aux secondes.

Il peut également comprendre un second ordonnanceur de fréquences résidant sur le terminal relais et recevant en entrée lesdites données estimées d'information systématique et lesdites secondes données de parité et allouant les porteuses à fort évanouissement aux premières et les porteuses à faible évanouissement aux secondes.

Selon une première variante, la partition entre porteuses à faible évanouissement et porteuses à fort évanouissement utilisée par le second ordonnanceur est déterminée par le terminal source et une information indicative de cette partition est transmise au terminal relais.

Ladite partition peut alors être déterminée par le terminal source à partir d'un indicateur de qualité de canal renvoyé par le terminal de destination.

Selon un second mode de réalisation, la partition entre porteuses à faible évanouissement et porteuses à fort évanouissement utilisée par le second ordonnanceur est déterminée de manière autonome par le terminal relais.

Ladite partition peut alors être déterminée par le terminal relais à partir d'un indicateur de qualité de canal renvoyé par le terminal de destination.

Selon un exemple préférentiel d'application, les premier et second canaux multiporteuse sont des canaux OFDM.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

La Fig. 1 illustre de manière schématique un système de télécommunication sans fil de type coopératif ;
La Fig. 2 illustre de manière schématique la structure d'un turbocodeur connu de l'état de la technique ;
La Fig. 3 illustre de manière schématique la structure d'un turbocodeur distribué connu de l'état de la technique ;
La Fig. 4 illustre l'état d'un canal de transmission multi-porteuse à évanouissements par blocs ;
La Fig.5 illustre de manière schématique la structure d'un turbocodeur distribué avec ordonnancement fréquentiel selon une première variante de réalisation de l'invention ;
La Fig. 6 donne un exemple d'ordonnancement fréquentiel pour le turbocodeur de la Fig. 5 ;
La Fig. 7 illustre de manière schématique la structure d'un turbocodeur distribué avec ordonnancement fréquentiel selon une seconde variante de réalisation de l'invention ;
La Fig. 8 illustre de manière schématique la structure d'un turbocodeur distribué avec ordonnancement fréquentiel selon une troisième variante de réalisation de l'invention.

## EXPOSÉ DÉTAILLÉ DE MODES DE RÉALISATION PARTICULIERS

Nous considérerons dans la suite un système de communication coopératif comprenant un terminal source $s$, au moins un terminal relais $r$, et un terminal de destination $d$. L'expression « terminal source » doit être prise au sens large, la présente invention pouvant notamment concerner le cas où une station de base transmet des données au terminal d'un usager sur sa liaison descendante. De la même façon l'expression « terminal de destination » doit être comprise au sens large, la présente invention concernant également le cas où un terminal source transmet des données à une station de base sur sa liaison montante. Dans les deux cas indiqués, les données sont relayées par le terminal relais, soit vers la station de base pour la liaison montante, soit vers le terminal de l'usager pour la liaison descendante.

Les canaux de transmission seront supposés être de type à évanouissements par blocs (*block fading* channel), hypothèse réaliste pour modéliser la plupart des liaisons sans fil. Dans un canal à évanouissements par blocs, un message à transmettre, par exemple un mot de code, voit une pluralité d'instances de canal. Ces instances peuvent être temporelles et/ou fréquentielles selon que le canal est sélectif en temps ou en fréquence. Nous considérerons par la suite que la transmission est effectuée au moyen d'un signal multi-porteuse, par exemple au moyen d'un multiplex OFDM (*Orthogonal Frequency Division Multiplexing*). Dans ce cas, si $N_c$ est le nombre de porteuses (plus précisément de sous-porteuses dans le cas d'une transmission OFDM), les instances de canal vues par un mot de code sont des blocs de fréquences ou *« frequency chunks »* subissant sensiblement le même évanouissement.

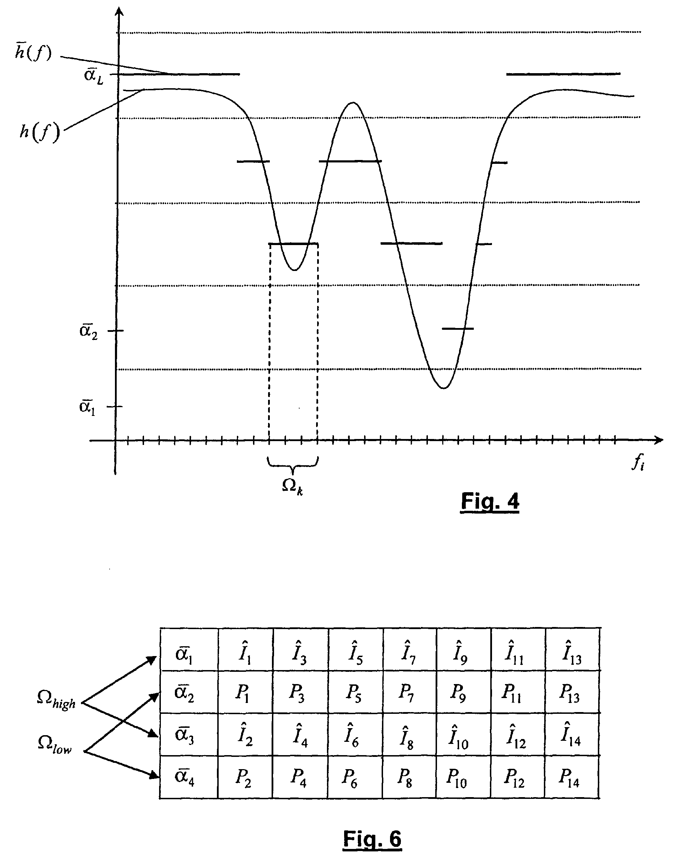

On a représenté en Fig. 4, à titre d'illustration, l'état d'un canal de transmission OFDM à évanouissements par blocs à un instant donné. La fonction de transfert $h(f)$ du canal peut être quantifiée au moyen d'une pluralité $L$ de niveaux de quantification notés $\overline{\alpha}_1,...,\overline{\alpha}_L$, encore appelés instances fréquentielles du canal. La fonction de transfert du canal peut alors approximée par une fonction $\overline{h}(f)$ quantifiée. Les porteuses contiguës $f_i$ dont les coefficients de transmission quantifiés respectifs $\overline{h}(f_i)$ sont de même valeur peuvent être groupées sous forme d'un intervalle. Ainsi la fonction $\overline{h}(f)$

peut-elle être considérée comme une fonction définie par intervalles $\Omega_1,...,\Omega_K$ où $\displaystyle\Omega=\bigcup_{k=1}^{K}\Omega_k$ est l'ensemble des porteuses. Deux intervalles disjoints peuvent correspondre à une même instance fréquentielle. Par construction, deux intervalles adjacents $\Omega_k,\Omega_{k+1}$ correspondent à des instances distinctes. Un intervalle $\Omega_k$ peut être réduit à un singleton.

Dans le cas illustré en Fig. 4, le canal est défini par cinq instances de canal ($L$=5) et neuf intervalles de porteuses ($K$=9).

Il convient de noter qu'en règle générale l'état du canal peut varier d'un mot de code à l'autre, autrement dit la fonction $\overline{h}(f)$ n'est pas nécessairement constante dans le temps.

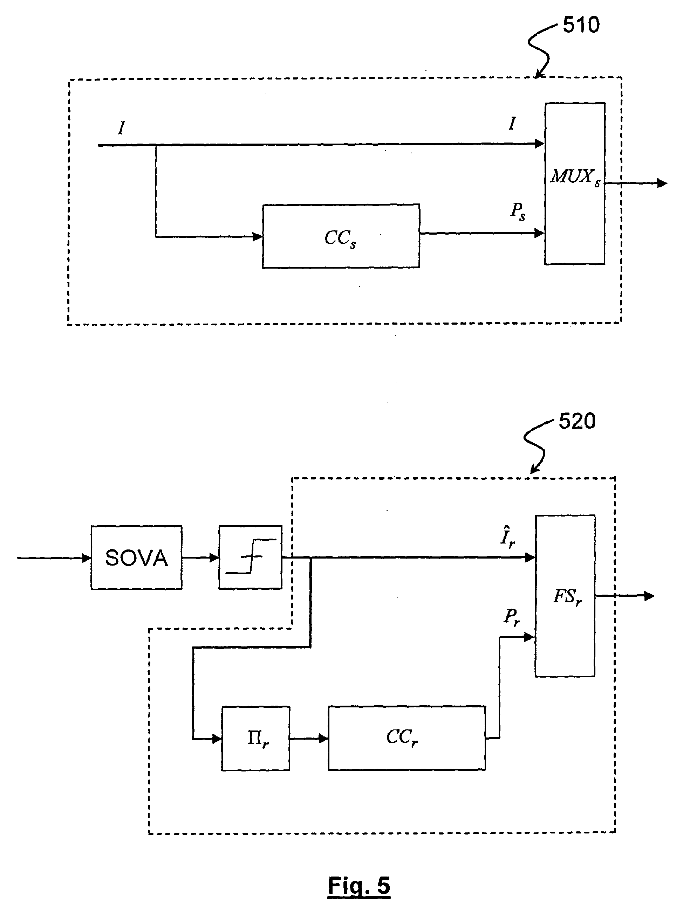

La Fig. 5 illustre un premier mode de réalisation d'un turbocodeur distribué selon un premier mode de réalisation de l'invention. On a représenté en 510 la partie du turbocodeur résidant sur le terminal source s et en 520 celle résidant sur le terminal relais $r$.

La première partie 510 comprend une première voie systématique fournissant directement les bits d'information *I* et une première voie de codage convolutif fournissant des premiers bits de parité $P_s$. La première voie de codage convolutif reçoit les bits d'information *I* et les code au moyen d'un premier codeur convolutif $CC_s$. Le codeur $CC_s$ est plus précisément un codeur convolutif de type récursif.

Un multiplexeur $MUX_s$ sélectionne alternativement un bit d'information systématique et un bit de parité. Les bits en sortie du multiplexeur sont ensuite transformés en symboles d'un alphabet de modulation grâce à un modulateur *M*-aire à symbole (non représenté) avant de moduler les différentes porteuses. Dans l'hypothèse d'une modulation BPSK (*Binary Phase Shift Keying*), chaque symbole BPSK module une fréquence différente et donc chaque bit d'information systématique ou de parité est donc associé à une porteuse différente. Le signal multi-porteuse, par exemple le signal OFDM, peut être ensuite, le cas échéant, translaté en bande RF.

Le terminal relais *r* reçoit le signal multi-porteuse du terminal source, le cas échéant après avoir effectué une translation en bande de base. Une démodulation du signal multi-porteuse permet de récupérer les valeurs souples ($\tilde{I}$, $\tilde{P}_S$) des bits d'information systématique et de bits de parité. Ces valeurs souples sont fournies à un décodeur de type SISO correspondant au codeur convolutif du terminal source, par exemple un décodeur de Viterbi à sorties souples (SOVA).

Le décodeur SISO fournit en sortie des valeurs souples des bits d'information systématique $\tilde{I}$. Ces valeurs souples sont soumises à une décision dure pour fournir des bits estimés $\hat{I}_r$.

La seconde partie 520 du turbocodeur distribué reçoit les bits d'information systématique ainsi estimés. Elle comprend elle-même une seconde voie systématique fournissant directement les bits estimés $\hat{I}_r$ et une seconde voie de codage convolutif fournissant des seconds bits de parité $P_r$. La seconde voie de codage convolutif reçoit les bits estimés, les entrelace au moyen d'un entrelaceur $\Pi$, et code les bits ainsi entrelacés au moyen d'un codeur convolutif $CC_r$. Le codeur $CC_r$ est plus précisément un codeur convolutif de type récursif.

Les secondes voies systématique et de codage convolutif fournissent les bits $\hat{I}_r$ et $P_r$ à un ordonnanceur fréquentiel (*frequency scheduler*) $FS_r$ qui leur alloue des porteuses selon une règle d'allocation décrite en détail plus loin. Les *M* bits alloués à une porteuses sont transformés en symbole de l'alphabet de modulation au moyen d'un modulateur *M* -aire à symbole (non représenté) et les symboles ainsi obtenus modulent les différentes porteuses. Le signal multi-porteuse qui en résulte est transmis par le terminal relais, le cas échéant après une translation en fréquence RF.

La stratégie d'allocation de fréquences vise à transmettre les bits de parité $P_r$ sur les porteuses présentant un faible évanouissement et les bits systématiques présentant un plus fort évanouissement. Autrement dit, l'ensemble $\Omega$ des porteuses est divisé en un premier sous-ensemble de porteuses $\Omega_{low}$, dont les coefficients de transmission respectifs sont supérieurs à une valeur de seuil (faible évanouissement) et un second sous-ensemble $\Omega_{high}$ dont les coefficients de transmission respectifs sont inférieurs à cette valeur de seuil (fort évanouissement, deep *fading*). Plus précisément, la transmission sur le canal entre le terminal relais *r* et le terminal de destination *d* peut être représentée par :

$$\mathbf{y_{rd}} = \mathbf{H_{rd}x_r} + \mathbf{n_{rd}} \qquad (1)$$

où $\mathbf{x_r}$ est un vecteur de dimension $N_c$ dont les composantes sont les symboles de modulation portés par les différentes porteuses, $\mathbf{H_{rd}} = Diag(\alpha_1,...,\alpha_{Nc})$ est une matrice diagonale de taille $N_c \times N_c$ dont les éléments diagonaux sont les coefficients de transmission des différentes porteuses, $\mathbf{n_{rd}}$ est un vecteur de dimension $N_c$ de composantes de bruit, $\mathbf{y_{rd}}$ est le vecteur des symboles reçus par le terminal de destination *d*. Les coefficients $\alpha_n$, $n=1,...,N_c$ sont comparés à une valeur de seuil prédéterminée $\alpha_T$. On définit alors :

$$\Omega_{low} = \left\{ f_n \big| \alpha_n > \alpha_T \right\} \quad \text{et} \quad \Omega_{high} = \left\{ f_n \big| \alpha_n \leq \alpha_T \right\} \qquad (2)$$

Selon une variante, si les coefficients de transmission ont préalablement fait l'objet d'une quantification sur *L* niveaux $\bar{\alpha}_1,...,\bar{\alpha}_L$, les sous-ensembles $\Omega_{low}$ et $\Omega_{high}$ peuvent être définis par :

$$\Omega_{low} = \bigcup_{\alpha_k > \alpha_T} \Omega_k \quad \text{et} \quad \Omega_{high} = \bigcup_{\alpha_k \leq \alpha_T} \Omega_k \qquad (3)$$

Dans tous les cas, les seconds bits de parité $P_r$ sont transmis dans des conditions plus favorables que les bits systématiques $\hat{I}_r$. L'idée à la base de l'invention est de garantir, autant que faire se peut, à la fois la dimension du turbocode et la diversité spatiale introduite par le relais. En effet si l'on suppose que les seconds bits de parité ne peuvent être décodés par le terminal de destination du fait d'un fort évanouissement on perd le bénéfice de l'entrelacement et du second codage convolutif et l'on réduit la dimension effective du turbocode.

La règle d'ordonnancement de l'ordonnanceur peut être contrôlée de différentes manières.

Selon une première variante, par exemple si le terminal source et le terminal relais ne sont pas très éloignés l'un de l'autre (les canaux de transmission source-destination et relais-destination sont alors similaires), le terminal source peut déterminer grâce à un indicateur de qualité de canal ou CQI (*Channel Quality Indicator*) les fréquences affectées par un fort évanouissement et en déduire le sous-ensemble $\Omega_{high}$ et son complémentaire $\Omega_{low}$. L'information sur la partition ($\Omega_{high},\Omega_{low}$) peut être transmise par le terminal source au terminal relais au moyen d'un canal auxiliaire (non représenté). Par exemple, un ensemble prédéterminé de partitions de $\Omega$ peut être indexé à l'aide d'une information de partition transmise sur le canal auxiliaire. Alternativement, l'information de partition peut être incorporée dans un en-tête du message à transmettre. Il convient de noter que de toutes façons l'information de partition doit être transmise au terminal de destination. Ce dernier doit en effet connaître la règle d'ordonnancement utilisée au niveau du terminal relais pour pouvoir effectuer le décodage.

Selon une seconde variante, la règle d'ordonnancement peut être contrôlée de manière autonome par le terminal relais. Par exemple, si le terminal relais transmet des données propres au terminal de destination, ce qui sera fréquemment le cas si ce dernier est une station de base, il pourra déterminer la partition ($\Omega_{high},\Omega_{low}$) *à* partir de l'indicateur de qualité (CQI) du canal relais-destination. Alternativement, si le terminal relais reçoit des données du terminal destination, c'est-à-dire sur sa liaison descendante si le terminal de destination est une station de base, il pourra, en supposant le canal réciproque, déterminer les coefficients d'atténuation des différentes porteuses grâce aux symboles pilotes reçus et en déduire la partition ($\Omega_{high},\Omega_{low}$).

La Fig. 6 donne un exemple d'ordonnancement fréquentiel pour un canal de transmission entre le terminal relais *r* et le terminal de destination *d,* à quatre instances $\overline{\alpha}_1$=0.4 ; $\overline{\alpha}_2$=0.8 ; $\overline{\alpha}_3$=0.2 ; $\overline{\alpha}_4$=0.6 . L'ensemble $\Omega_{low}$ est constitué des porteuses dont le coefficient d'atténuation est quantifié par $\overline{\alpha}_2$ ou $\overline{\alpha}_4$ L'ensemble $\Omega_{high}$ est constitué des porteuses dont le coefficient d'atténuation est quantifié par $\overline{\alpha}_1$ ou $\overline{\alpha}_3$ On a supposé que le mot de code à transmettre était constitué de 14 bits $I_1,...,I_{14}$. Les bits de parité fournis par le codeur $CC_r$ à partir des valeurs estimées $\hat{I}_1,...,\hat{I}_{14}$ sont désignés ici par $P_{r1},...,P_{r14}$. Le canal est supposé invariant pendant le temps de transmission du mot de code. On voit sur le tableau d'ordonnancement que les bits systématiques $\hat{I}_1,...,\hat{I}_{14}$ sont distribués sur les porteuses appartenant à l'ensemble $\Omega_{high}$ et que les bits de parité $P_{r1},...,P_{r14}$ sont distribués sur les porteuses appartenant à l'ensemble $\Omega_{low}$.

L'homme du métier comprendra que le mode de réalisation précédemment décrit peut se généraliser à un turbocodeur distribué sur un nombre quelconque de terminaux relais. Le terminal source tout comme les terminaux relais ne présentent pas nécessairement une seule dimension du turbocode, en d'autres termes une seule voie de codage convolutif, mais peuvent comprendre une pluralité de telles voies. Par exemple, si le système de communication coopératif comprend une pluralité de terminaux relais $r_1,...,r_J$, la dimension totale du turbocode sera $D = 1 + \sum_{j=1}^{J} \nu_j$

où $\nu_j$ est le nombre de voies de codage convolutif du terminal relais $r_j$, et où le terme 1 représente la voie systématique.

Du côté du récepteur du terminal de destination, les valeurs souples des bits systématiques $I, \hat{I}r_1,..., \hat{I}_{rJ}$ reçus respectivement du terminal source et des terminaux relais sont combinées au moyen d'une combinaison MRC (Maximum Ratio Combining), pour fournir une valeur souple composite. Les valeurs souples composites de bits systématiques ainsi que les valeurs souples des bits de parité reçues respectivement des $\sum_{j=1}^{J} \nu_j$ voies de codage convolutif sont décodées de manière conventionnelle au moyen d'un turbodécodeur comprenant autant de décodeurs élémentaires de type SISO (Soft Input Soft Output) ou de type MAP (*Maximum A Posteriori*) que de voies de codage. Le décodage est effectué de manière connue en soi par itérations successives, chaque décodeur fournissant à chaque itération aux autres décodeurs les informations extrinsèques associées aux différents bits pour l'itération suivante. Il n'y a donc pas de complexité additionnelle par rapport à un turbo-décodage classique.

Le système de communication coopératif de la Fig. 5 fonctionne bien lorsque le canal de transmission entre le terminal source et le terminal de destination n'est pas soumis à des forts évanouissements (deep *fading*). Dans le cas inverse, on préfère alors utiliser un système de communication coopératif selon un second mode de réalisation de l'invention.

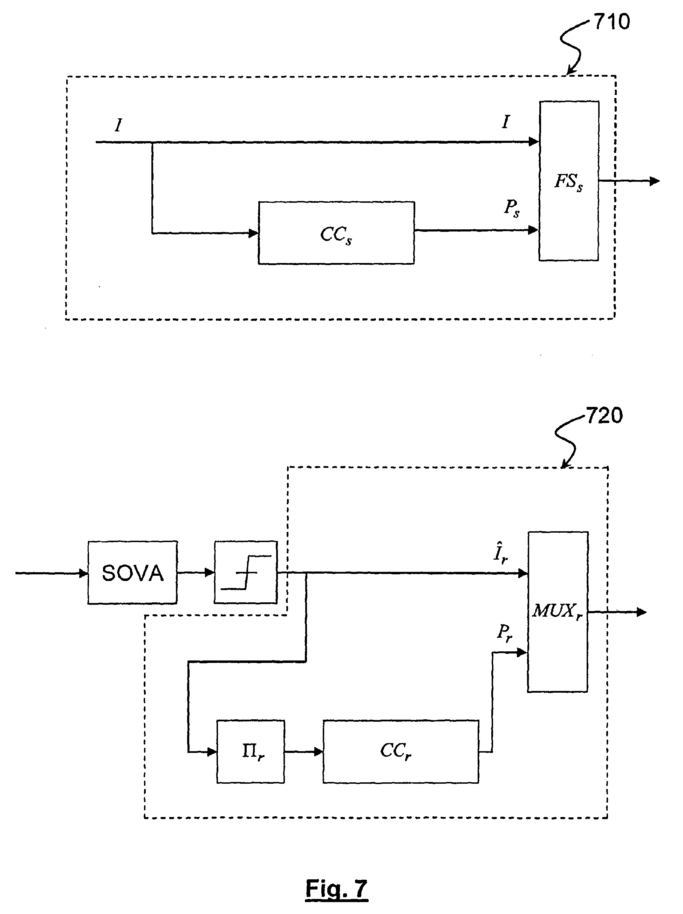

La Fig. 7 illustre un turbocodeur distribué selon un second mode de réalisation de l'invention. A l'inverse du mode de réalisation précédent, l'ordonnancement fréquentiel est réalisé ici dans la partie 710 du turbocodeur résidant sur le terminal source, la seconde partie, 720, résidant sur le terminal relais n'effectuant qu'un multiplexage en sélectionnant alternativement ou aléatoirement les bits systématiques estimés $\hat{I}_r$ et les bits de parité $P_r$. Le fonctionnement

de l'ordonnanceur fréquentiel $FS_s$ est identique à celui de l'ordonnanceur fréquentiel $FS_r$ du premier mode de réalisation, à la différence près qu'il opère sur les bits d'information systématique $I$ et les bits de parité $P_s$. Dans ce mode de réalisation, la partition $(\Omega_{high}, \Omega_{low})$ est déterminée par le terminal source lui-même. L'information est cependant transmise sur un canal auxiliaire ou dans un en-tête, tant au terminal relais qu'au terminal de destination, qui ont tous deux besoin de connaître la règle d'ordonnancement pour pouvoir effectuer leurs opérations de décodage respectives.

Le second mode de réalisation donne de bons résultats lorsque le canal de transmission entre le terminal relais et le terminal de destination n'est pas sujet à de forts évanouissements. Dès lors que les deux canaux de transmission source-destination et relais-destination peuvent être affectés par des évanouissements, le troisième mode de réalisation est préféré.

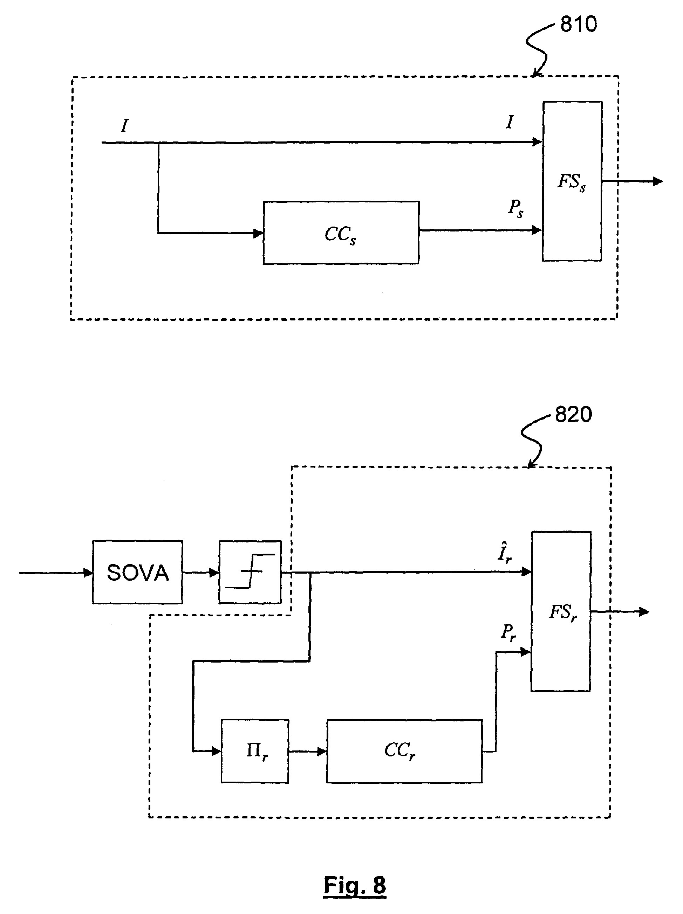

La Fig. 8 représente un turbocodeur distribué selon un troisième mode de réalisation de l'invention. La première partie du turbocodeur, 810, résidant sur le terminal source a la même structure dans le second mode de réalisation et la seconde partie, 820, résidant sur le terminal relais, a la même structure que dans le premier mode de réalisation. On conçoit ainsi que les bits de parité $P_s$ et $P_r$ sont transmis de manière privilégiée sur les canaux de transmission source-destination et relais-destination, de sorte que la dimension du code est préservée au mieux.

La règle d'ordonnancement utilisée dans l'ordonnanceur $FS_s$ est déterminée par le terminal source comme expliqué dans le second mode de réalisation. La règle d'ordonnancement utilisée dans l'ordonnanceur $FS_r$ est déterminée par le terminal source - c'est alors la même que celle utilisée par $FS_s$ - soit, de manière autonome par le terminal relais comme expliqué dans le premier mode de réalisation.

Les ordonnanceurs $FS_s$ et/ou $FS_r$ utilisent de préférence une règle d'ordonnancement dynamique, celle-ci pouvant être par exemple rafraîchie à chaque nouveau mot de code ou bien selon une périodicité fonction de la rapidité d'évolution du canal.

## Revendications

1. Système de communication coopératif comprenant un terminal source ($s$), au moins un terminal relais ($r$), et un terminal de destination ($d$), le terminal source étant adapté à transmettre des données d'information ($I$) au terminal de destination sur un premier canal de transmission multi-porteuse, ledit système comprenant un turbocodeur distribué entre ledit terminal source et au moins ledit terminal relais, la partie du turbocodeur résidant sur le terminal source, dite première partie (510, 710, 810) comprenant une première voie systématique et au moins une première voie de codage convolutif $(CC_s)$ codant lesdites données d'information pour générer des premières données de parité ($P_s$), le terminal relais estimant lesdites données d'information à partir d'un signal reçu du terminal source, la partie du turbocodeur résidant sur le terminal relais, dite seconde partie (520, 720, 820) comprenant une seconde voie systématique fournissant les données d'information ainsi estimées ($\hat{I}_r$) et une seconde voie de codage convolutif $(CC_r)$ codant celles-ci après les avoir entrelacées pour générer des secondes données de parité ($P_r$), lesdites données estimées ($\hat{I}_r$) et lesdites secondes données de parité ($P_r$) étant transmises sur un second canal de transmission multi-porteuse, **caractérisé en ce que** ledit système comprend au moins un ordonnanceur de fréquences $(FS_s, FS_r)$ résidant sur le terminal source ou le terminal relais, ledit ordonnanceur allouant les porteuses $(\Omega_{high})$ présentant un fort évanouissement aux données issues respectivement de la première ou de la seconde voie systématique et les porteuses présentant un faible évanouissement $(\Omega_{low})$ aux données issues respectivement de la première ou de la seconde voie de codage convolutif.

2. Système de communication coopératif selon la revendication 1, **caractérisé en ce qu'**il comprend un premier ordonnanceur de fréquences $(FS_s)$ résidant sur le terminal source et recevant en entrée lesdites données d'information systématique ($I$) et lesdites premières données de parité ($P_s$) et allouant les porteuses à fort évanouissement aux premières et les porteuses à faible évanouissement aux secondes.

3. Système de communication coopératif selon la revendication 1 ou 2, **caractérisé en ce qu'**il comprend un second ordonnanceur de fréquences $(FS_r)$ résidant sur le terminal relais et recevant en entrée lesdites données estimées d'information systématique et lesdites secondes données de parité ($P_r$) et allouant les porteuses à fort évanouissement aux premières et les porteuses à faible évanouissement aux secondes.

4. Dispositif de communication coopératif selon la revendication 3, **caractérisé en ce que** la partition entre porteuses à faible évanouissement $(\Omega_{low})$ et porteuses à fort évanouissement $(\Omega_{high})$ utilisée par le second ordonnanceur $(FS_r)$) est déterminée par le terminal source et qu'une information indicative de cette partition est transmise au terminal relais.

5. Dispositif de communication coopératif selon la revendication 4, **caractérisé en ce que** ladite partition est déterminée par le terminal source à partir d'un indicateur de qualité de canal (CQI) renvoyé par le terminal de destination.

6. Dispositif de communication coopératif selon la revendication 3, **caractérisé en ce que** la partition entre porteuses à faible évanouissement ($\Omega_{low}$) et porteuses à fort évanouissement ($\Omega_{high}$) utilisée par le second ordonnanceur est déterminée de manière autonome par le terminal relais.

7. Dispositif de communication coopératif selon la revendication 6, **caractérisé en ce que** ladite partition est déterminée par le terminal relais à partir d'un indicateur de qualité de canal (CQI) renvoyé par le terminal de destination.

8. Dispositif de communication coopératif selon l'une des revendications précédentes, **caractérisé en ce que** les premier et second canaux multiporteuse sont des canaux OFDM.

**Claims**

1. A cooperative communications system comprising a source terminal (*s*), at least one relay terminal (*r*), and a destination terminal (*d*), the source terminal being adapted to transmit information data (*I*) to the destination terminal over a first multi-carrier transmission channel, said system comprising a distributed turbocoder over said source terminal and at least said relay terminal, the part of the turbocoder residing on the source terminal, referred to as first part (510, 710, 810), comprising a first systematic path and at least one first convolutive coding path ($CC_s$) coding said information data to generate first parity data ($P_s$), the relay terminal estimating said information data from a signal received from the source terminal, the part of the turbocoder residing on the relay terminal, referred to as second part (520, 720, 820), comprising a second systematic path providing the information data thus estimated ($\hat{I}_r$) and a second convolutive coding path ($CC_r$) coding the latter after having interleaved them to generate second parity data ($P_r$), said estimated data ($\hat{I}_r$) and said second parity data ($P_r$) being transmitted over a second multi-carrier transmission channel, **characterised in that** said system comprises at least one frequency scheduler ($FS_s$, $FS_r$) residing on the source terminal or the relay terminal, said scheduler allocating the carriers ($\Omega_{high}$) exhibiting deep fading to the data originating respectively from the first or the second systematic path and the carriers exhibiting weak fading ($\Omega_{low}$) to the data originating respectively from the first or the second convolutive coding path.

2. The cooperative communications system as claimed in Claim 1, **characterised in that** it comprises a first frequency scheduler ($FS_s$) residing on the source terminal and receiving at input said systematic information data (*I*) and said first parity data ($P_s$) and allocating the deep-fading carriers to the first and the weak-fading carriers to the second.

3. The cooperative communications system as claimed in Claim 1 or 2, **characterised in that** it comprises a second frequency scheduler ($FS_r$) residing on the relay terminal and receiving at input said estimated systematic information data and said second parity data ($P_r$) and allocating the deep-fading carriers to the first and the weak-fading carriers to the second.

4. A cooperative communications device as claimed in Claim 3, **characterised in that** the partition between weak-fading carriers ($\Omega_{low}$) and deep-fading carriers ($\Omega_{high}$) utilised by the second scheduler ($FS_r$)) is determined by the source terminal and **in that** information indicative of this partition is transmitted to the relay terminal.

5. The cooperative communications device as claimed in Claim 4, **characterised in that** said partition is determined by the source terminal from a channel quality indicator (CQI) sent by the destination terminal.

6. The cooperative communications device as claimed in Claim 3, **characterised in that** the partition between weak-fading carriers ($\Omega_{low}$) and deep-fading carriers ($\Omega_{high}$) utilised by the second scheduler is determined autonomously by the relay terminal.

7. The cooperative communications device as claimed in Claim 6, **characterised in that** said partition is determined by the relay terminal from a channel quality indicator (CQI) sent by the destination terminal.

8. The cooperative communications device as claimed in any one of the preceding claims, **characterised in that** the first and second multicarrier channels are OFDM channels.

**Patentansprüche**

1. System zur kooperativen Kommunikation, umfassend ein Quellenterminal (*s*), wenigstens ein Relaisterminal (*r*) sowie ein Zielterminal (*d*), wobei das Quellenterminal dazu ausgelegt ist, Informationsdaten (*I*) auf einem ersten Multiträger-Übertragungskanal an das Zielterminal zu übertragen, wobei das System einen zwischen dem Quellenterminal und wenigstens dem Relaisterminal verteilten Turbocodierer umfasst, wobei der Teil des Turbocodierers, der bei dem Quellenterminal angeordnet ist, genannt erster Teil (510, 710, 810), einen ersten systematischen Weg und wenigstens einen ersten Faltungscodierweg ($CC_s$) umfasst zum Codieren der Informationsdaten, um erste Paritätsdaten ($P_s$) zu erzeugen, wobei das Relaisterminal die Informationsdaten ausgehend von einem vom Quellenterminal empfangenen Signal abschätzt, wobei der Teil des Turbocodierers, der bei dem Relaisterminal angeordnet ist, genannt zweiter Teil (520, 720, 820), einen zweiten systematischen Weg umfasst, der die derart abgeschätzten Informationsdaten ($\hat{I}_r$) liefert, sowie einen zweiten Faltungscodierweg ($CC_r$) zum Codieren derselben, nachdem sie verschachtelt wurden, um zweite Paritätsdaten ($P_r$) zu erzeugen, wobei die abgeschätzten Daten ($\hat{I}_r$) und die zweiten Paritätsdaten ($P_r$) auf einem zweiten Multiträger-Übertragungskanal übertragen werden, **dadurch gekennzeichnet, dass** das System wenigstens eine Frequenzsteuereinrichtung ($FS_s, FS_r$) umfasst, die bei dem Quellenterminal oder bei dem Relaisterminal angeordnet ist, wobei die Steuereinrichtung die Träger ($\Omega_{high}$), die einen starken Schwund aufweisen, denjenigen Daten zuweist, die aus dem ersten beziehungsweise aus dem zweiten systematischen Weg stammen, und die Träger, die einen schwachen Schwund aufweisen ($\Omega_{low}$) denjenigen Daten, die aus dem ersten beziehungsweise aus dem zweiten Faltungscodierweg stammen.

2. System zur kooperativen Kommunikation nach Anspruch 1, **dadurch gekennzeichnet, dass** es eine erste Frequenzsteuereinrichtung ($FS_s$) umfasst, die bei dem Quellenterminal angeordnet ist und am Eingang die Daten der systematischen Information (*I*) und die ersten Paritätsdaten ($P_s$) empfängt und die Träger mit starkem Schwund den erstgenannten und die Träger mit schwachem Schwund den zweitgenannten zuweist.

3. System zur kooperativen Kommunikation nach Anspruch 1 oder 2, **dadurch gekennzeichnet, dass** es eine zweite Frequenzsteuereinrichtung ($FS_r$) umfasst, die bei dem Relaisterminal angeordnet ist und am Eingang die abgeschätzten Daten der systematischen Information und die zweiten Paritätsdaten ($P_r$) empfängt und die Träger mit starkem Schwund den erstgenannten und die Träger mit schwachem Schwund den zweitgenannten zuweist.

4. Vorrichtung zur kooperativen Kommunikation nach Anspruch 3, **dadurch gekennzeichnet, dass** die Aufteilung zwischen Trägern mit schwachem Schwund ($\Omega_{low}$) und Trägern mit starkem Schwund ($\Omega_{high}$), die von der zweiten Steuereinrichtung ($FS_r$) verwendet wird, durch das Quellenterminal bestimmt wird, und dass eine Information, die diese Aufteilung anzeigt, an das Relaisterminal übertragen wird.

5. Vorrichtung zur kooperativen Kommunikation nach Anspruch 4, **dadurch gekennzeichnet, dass** die Aufteilung durch das Quellenterminal ausgehend von einer Kanalqualitätsangabe (*CQI*) bestimmt wird, die durch das Zielterminal zurückgeschickt wird.

6. Vorrichtung zur kooperativen Kommunikation nach Anspruch 3, **dadurch gekennzeichnet, dass** die Aufteilung zwischen Trägern mit schwachem Schwund ($\Omega_{low}$) und Trägern mit starkem Schwund ($\Omega_{high}$), die durch die zweite Steuereinrichtung verwendet wird, in autonomer Weise von dem Relaisterminal bestimmt wird.

7. Vorrichtung zur kooperativen Kommunikation nach Anspruch 6, **dadurch gekennzeichnet, dass** die Aufteilung von dem Relaisterminal ausgehend von einer Kanalqualitätsangabe (*CQI*) bestimmt wird, die von dem Zielterminal zurückgeschickt wird.

8. Vorrichtung zur kooperativen Kommunikation nach einem der vorhergehenden Ansprüche, **dadurch gekennzeichnet, dass** der erste und der zweite Multiträger-Kanal OFDM-Kanäle sind.

**Fig. 1**

**Fig. 2**

**Fig. 3**

**Fig. 4**

**Fig. 6**

510

$I$

$I$

$MUX_s$

$CC_s$

$P_s$

520

SOVA

$\hat{I}_r$

$FS_r$

$P_r$

$\Pi_r$

$CC_r$

**Fig. 5**

710

$I$                         $I$

$FS_s$

$P_s$

$CC_s$

720

SOVA

$\hat{I}_r$

$MUX_r$

$P_r$

$\Pi_r$

$CC_r$

**Fig. 7**

**Fig. 8**

**RÉFÉRENCES CITÉES DANS LA DESCRIPTION**

**Documents brevets cités dans la description**

- WO 2008109912 A
- FR 2800947
- US 2008065946 A
- WO 2007064249 A

**Littérature non-brevet citée dans la description**

- **J.N LANEMANN ; G.W. WORNELL.** Exploiting distributed spatial diversity in wireless networks. *Proc. Allerton Conf. on Comm,. Contr., Computing,* 2000
- **C. BERROU et al.** Near Shannon limit error-correcting coding and decoding : Turbo Codes. *Proceedings of ICC'93,* 1064-1070
- **D. DIVSALAR et al.** Multiple turbo codes. *Proc. IEEE MILCOM,* 1995, 279-285
- **M. JANANI et al.** Coded cooperation in wireless communications : space-time transmission and iterative decoding. *IEEE Trans. Signal Process.,* Février 2004, vol. 52 (2), 362-371
- **VALENTI M C et al.** Distributed turbo codes: towards the capacity of the relay channel. *VEHICULAR TECHNOLOGY CONFERENCE, 2003. VTC 2003-FALL. 2003 IEEE 58th ORLANDO, FL, USA 6-9 Oct. 2003; IEEE VEHICULAR TECHNOLGY CONFERENCE, PISCATAWAY, NJ, USA,IEEE, US,* 06 Octobre 2003, vol. 1, ISBN 978-0-7803-7954-1, 322-326
- **ZHAO B et al.** Distributed turbo coded diversity for relay channel. *ELECTRONICS LETTERS, IEE STEVENAGE, GB,* 15 Mai 2003, vol. 39 (10), ISSN 0013-5194, 786-787